# EUROPEAN PATENT APPLICATION

(11) **EP 1 610 398 A2**
(43) Date of publication of application: **28.12.2005**
(21) Application number: 05105431.0
(22) Date of filing: 21.06.2005
(51) Int. Cl.: H01L 51/30

(54) **Organic electroluminescent device**

(30) Priority: 25.06.2004 KR 2004048051
(71) Applicant: Samsung SDI Co., Ltd., Suwon-si Gyeonggi-do (KR)
(72) Inventor: Lee, Jun-Yeob Legal & IP Team, Kiheung-Eup, Yongin-si, Gyeonggi-do (KR); Chun, Min-Seung Legal & IP Team, Kiheung-Eup, Yongin-si, Gyeonggi-do (KR); Choi, Yong-Joong, Yeongtong-gu, Suwon-si, Gyeonggi-do (KR)
(74) Representative: Hengelhaupt, Jürgen

(57) **Abstract**

An organic EL device which has a light emission layer between a pair of electrodes. The light emission layer is formed of a phosphorescent dopant and a host including (i) a carbazole compound and (ii) one or more selected from an oxadiazole compound, a phenanthroline compound, a triazine compound, and a triazole compound. Since the host has both hole transport property and electron transport property, the organic EL device has enhanced emission efficiency and lifetime characteristics even in the absence of a hole-blocking layer.

## Description

### CLAIM OF PRIORITY

This application claims the priority of Korean Patent Application No. 10-2004-0048051, filed on June 25, 2004, in the Korean Intellectual Property Office, the disclosure of which is incorporated herein in its entirety by reference.

### BACKGROUND OF THE INVENTION

### 1. Field of the Invention

The present invention relates to an organic electroluminescent device, and more particularly, to an organic electroluminescent device with enhanced emission efficiency and lifetime characteristics using a light emission layer including a phosphorescent dopant.

### 2. Description of the Related Art

An emission material of organic electroluminescent (EL) devices is divided into a fluorescent material using a singlet exciton and a phosphorescent material using a triplet exciton according to an emission mechanism.

Generally, a phosphorescent material has a heavy atom-containing organometallic compound structure. By using the phosphorescent material, normally forbidden transition of a triplet exciton state is allowed so that the phosphorescent material may produce phosphorescent emission through a triplet exciton state. Since the phosphorescent material can use triplet excitons with the probability of formation of 75%, it can have much higher emission efficiency than a fluorescent material using singlet excitons with the probability of formation of 25%.

A light emission layer using a phosphorescent material is composed of a host material and a dopant material producing emission through energy transfer from the host material. As the dopant material, there have been reported many iridium-based dopant materials (Princeton University and University of Southern California, USA). In particular, as blue-emitting materials, iridium compounds carrying (4,6-F₂ppy)₂Irpic or fluorinated ppy (phenylpyridine) ligand structures were developed. As host materials for these materials, CBP (4,4'-N,N'-dicarbazole-biphenyl) molecules have been widely used. It has been reported that the energy band gaps of the triplet states of the CBP are sufficient to allow for energy transfer to green- or red-emitting materials but are smaller than the energy band gaps of blue-emitting materials, thereby leading to very inefficient endothermic energy transfer instead of exothermic energy transfer. For this reason, the CBP molecules as host materials provide insufficient energy transfer to blue-emitting dopants, thereby leading to problems of low blue-emission efficiency and short device lifetime.

Recently, there has been reported a method of forming a light emission layer using a phosphorescent dopant and a host material of a carbazole compound with a larger triplet energy band gap than CBP.

However, currently available organic EL devices using a carbazole-based phosphorescent material still have unsatisfactory emission efficiency and lifetime characteristics.

### SUMMARY OF THE INVENTION

It is therefore an object of the present invention to provide an improved organic EL device.

It is further an object of the present invention to provide an organic EL device with enhanced emission efficiency and lifetime characteristics.

According to an aspect of the present invention, an organic EL device may be constructed with a pair of electrodes and a light emission layer between the pair of electrodes, the light emission layer including a phosphorescent dopant and a host including (i) a carbazole compound and (ii) at least one selected from an oxadiazole compound, a phenanthroline compound, a triazine compound, and a triazole compound.

An electron transport layer may be directly formed on the light emission layer. That is, a hole blocking layer may be omitted.

According to still an aspect of the present invention, an organic EL device may be constructed with a substrate; an anode formed on the substrate; a hole injection layer formed on the anode; a light emission layer comprising a phosphorescent dopant and a host, the host comprising (i) a first compound comprising a carbazole compound and (ii) a second compound comprising at least one selected from the group consisting of an oxadiazole compound, a phenanthroline compound, a triazine compound, and a triazole compound; an electron transport layer formed on the light emission layer; and a cathode formed on the electron transport layer.

A hole transport layer may be further formed between the hole injection layer and the light emission layer. An electron injection layer may be formed between the electron transport layer and the cathode.

The exemplary oxadiazole compound is (4-biphenylyl)-5-(4-t-butylphenyl)-1,3,4-oxadiazole. The exemplary phenanthroline compound is 2,9-dimethyl-4,7-diphenyl-9,10-phenanthroline. The exemplary triazine compound is 2,4,6-tris(diarylamino)-1,3,5-triazine, 2,4,6-tris(diphenylamino)-1,3,5-triazine, 2,4,6-tricarbazolo-1,3,5-triazine, 2,4,6-tris(N-phenyl-2-naphthylamino)-1,3,5-triazine, 2,4,6-tris(N-pheyl-1-naphthylamino)-1,3,5-triazine, or 2,4,6-trisbiphenyl-1,3,5-triazine. The exemplary triazole compound is 3-phenyl-4-(1'-naphthyl)-5-phenyl-1,2,4-triazole. The exemplary carbazole compound is at least one selected from the group consisting of 1,3,5-tricarbazolylbenzene, 4,4'-biscarbazolylbiphenyl, polyvinylcarbazole, m-biscarbazolylphenyl, 4,4'-biscarbazolyl-2,2'-dimethylbiphenyl, 4',4"-tri(N-carbazolyl)triphenylamine, 1,3,5-tri(2-carbazolylphenyl)benzene, 1,3,5-tris(2-carbazolyl-5-methoxyphenyl)benzene, and bis(4-carbazolylphenyl)silane.

It is preferred that the content of the host in the light emission layer is 80 to 99 parts by weight, based on the total weight 100 parts by weight of the light emission layer.

It is preferred that the content of the second compound is 5 to 2,000 parts by weight, based on 100 parts by weight of the carbazole compound.

According to further an aspect of the present invention, an organic EL device may be constructed with a pair of electrodes; and an organic layer between the pair of electrodes, the organic layer comprising a light emission layer between the pair of electrodes and an absent hole blocking layer, the light emission layer comprising a phosphorescent dopant and a host, the host comprising (i) a hole transporting compound comprising a carbazole compound and (ii) a second compound comprising at least one selected from the group consisting of an oxadiazole compound, a phenanthroline compound, a triazine compound, and a triazole compound, the content of the host being 80 to 99 parts by weight based on the total weight 100 parts by weight of the light emission layer, the content of the second compound is 5 to 2,000 parts by weight based on 100 parts by weight of the hole transporting compound.

### BRIEF DESCRIPTION OF THE DRAWINGS

A more complete appreciation of the present invention, and many of the above and other features and advantages of the present invention, will be readily apparent as the same becomes better understood by reference to the following detailed description when considered in conjunction with the accompanying drawings in which like reference symbols indicate the same or similar components, wherein:

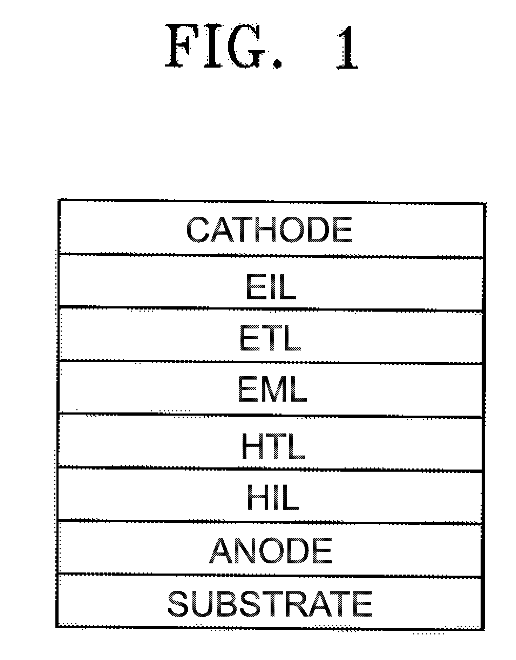

FIG. 1 illustrates a sectional view of an organic EL device according to an embodiment of the present invention.

### DETAILED DESCRIPTION OF THE PREFERRED EMBODIMENTS

Hereinafter, the present invention will be described in more detail.

According to the present invention, in formation of a light emission layer including a phosphorescent dopant, as a host, there is used a combination of a carbazole compound with hole transport property and one or more selected from an oxadiazole compound, a phenanthroline compound, a triazine compound, and a triazole compound with electron transport property. Therefore, there is no need to form a hole-blocking layer (HBL) so that fabrication of an organic EL device may be simplified, and emission efficiency and lifetime characteristics may be enhanced.

The oxadiazole compound may be (4-biphenylyl)-5-(4-t-butylphenyl)-1,3,4-oxadiazole. The phenanthroline compound may be 2,9-dimethyl-4,7-diphenyl-9,10-phenanthroline (BCP). The triazine compound may be 2,4,6-tris(diphenylamino)-1,3,5-triazine, 2,4,6-tricarbazoio-1,3,5-triazine, 2,4,6-tris(N-phenyl-2-naphthylamino)-1,3,5-triazine, or 2,4,6-tris(N-phenyl-1-naphthylamino)-1,3,5-triazine. The triazole compound may be 3-phenyl-4-(1'-naphthyl)-5-phenyl-1,2,4-triazole.

The carbazole compound may be one or more selected from the group consisting of 1,3,5-tricarbazolylbenzene, 4,4'-biscarbazolylbiphenyl, polyvinylcarbazole, m-biscarbazolylphenyl, 4,4'-biscarbazolyl-2,2'-dimethylbiphenyl, 4',4"-tri(N-carbazolyl)triphenylamine, 1,3,5-tri(2-carbazolylphenyl)benzene, 1,3,5-tris(2-carbazolyl-5-methoxyphenyl)benzene, and bis(4-carbazolylphenyl)silane.

Preferably, the content of the host in the light emission layer is 80 to 99 parts by weight, based on the total weight (100 parts by weight) of a light emission layer material, i.e., the total weight of the host and the dopant. If the content of the host is less than 80 parts by weight, triplet extinction may occur, thereby lowering emission efficiency. On the other hand, if it exceeds 99 parts by weight, an emission material may be insufficient, thereby lowering emission efficiency and lifetime.

Preferably, an electron transport material (i.e., the oxadiazole compound, the phenanthroline compound, the triazine compound, the triazole compound, or a mixture thereof) constituting the host is used in an amount of 5 to 2,000 parts by weight, based on 100 parts by weight of a hole transport material. If the content of the electron transport material is less than 5 parts by weight, a characteristics enhancement effect relative to a single host material may be insignificant. On the other hand, if it exceeds 2,000 parts by weight, a characteristics enhancement effect may not be observed.

The phosphorescent dopant used in formation of the light emission layer according to the present invention is an emission material. Examples of the phosphorescent dopant include but are not limited to bisthienylpyridine acetylacetonate iridium, bis(benzothienylpyridine)acetylacetonate iridium, bis(2-phenylbenzothiazole)acetylacetonate iridium, bis(1-phenylisoquinoline) iridium acetylacetonate, and tris(1-phenylisoquinoline) iridium.

Hereinafter, a method of manufacturing an organic EL device of the present invention will be described.

A method of manufacturing an organic EL device according to an embodiment of the present invention will now be described with reference to FIG. 1.

First, an anode material is coated on a substrate to form an anode used as a first electrode. The substrate may be a substrate commonly used for organic EL devices. Preferably, the substrate is a glass substrate or a transparent plastic substrate which is excellent in transparency, surface smoothness, handling property, and water resistance. The anode material may be a material which is excellent in transparency and conductivity, for example indium tin oxide (ITO), indium zinc oxide (IZO), tin oxide (SnO₂), or zinc oxide (ZnO).

A hole injection layer (HIL) is selectively formed on the anode by vacuum thermal deposition or spin-coating of a hole injection material on the anode. Preferably, the hole injection layer has a thickness of 50 to 1,500Å. If the thickness Å of the hole injection layer is less than 50Å, hole injection characteristics may be lowered. On the other hand, if it exceeds 1,500Å, a driving voltage may increase.

The hole injection layer material is not particularly restricted. Copper phthalocyanine (CuPc), Starburst amine such as TCTA and m-MTDATA (represented by the following structural formulae) or IDE406 (Idemitsu Kosan Co., Ltd.) may be used as the hole injection layer material:

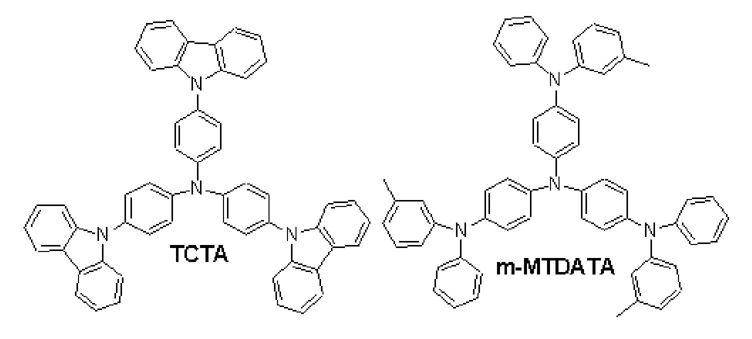

A hole transport layer (HTL) is selectively formed on the hole injection layer by vacuum thermal deposition or spin-coating of a hole transport layer material on the hole injection layer. The hole transport layer material is not particularly restricted. One of IDE320 (Idemitsu Kosan Co., Ltd.), N,N'-bis(3-methylphenyl)-N,N'-diphenyl-[1,1-biphenyl]-4,4'-diamine (TPD) and N,N'-di(naphthalene-1-yl)-N,N'-diphenyl benzidine (NPD) represented by the following structural formulae may be used as the hole transport layer material. Preferably, the hole transport layer has a thickness of 50 to 1,500Å. If the thickness of the hole transport layer is less than 50Å, hole transport characteristics may be lowered. On the other hand, if it exceeds 1,500Å, a driving voltage may increase.

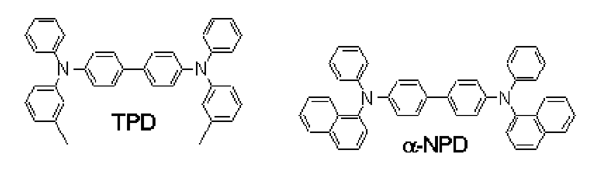

A light emission layer (EML) is formed on the hole transport layer using a phosphorescent dopant and a host of a mixture of an electron transport material and a hole transport material as described above. There are no particular limitations on a method of forming the light emission layer but vacuum deposition, inkjet printing, laser printing, photolithography, or the like may be used.

Preferably, the light emission layer has a thickness of 100 to 800Å. If the thickness of the light emission layer is less than 100Å, emission efficiency and lifetime may be lowered. On the other hand, if it exceeds 800Å, a driving voltage may increase.

In the case of forming a light emission layer including a phosphorescent dopant, it is common to form a hole-blocking layer (HBL) on the light emission layer by vacuum deposition or spin-coating of a hole blocking material on the light emission layer. However, an organic EL device of the present invention can have excellent emission efficiency and lifetime characteristics even in the absence of the hole-blocking layer.

An electron transport layer (ETL) is formed on the light emission layer by vacuum deposition or spin-coating of an electron transport layer material. There are no particular limitations on the electron transport layer material but Alq3 (tris(8-hydroxyquinoline) aluminum) may be used. Preferably, the electron transport layer has a thickness of 50 to 600Å. If the thickness of the electron transport layer is less than 50Å, lifetime characteristics may be lowered. On the other hand, if it exceeds 600Å, a driving voltage may increase.

An electron injection layer (EIL) may be selectively formed on the electron transport layer. An electron injection layer material may be LiF, NaCl, CsF, Li₂O, BaO, Liq represented by the following structural formula, etc. Preferably, the electron injection layer has a thickness of 1 to 100Å. If the thickness of the electron injection layer is less than 1Å, electron injection property may be poor, thereby increasing a driving voltage. On the other hand, if it exceeds 100Å, the electron injection layer may serve as an insulating layer, thereby increasing a driving voltage:

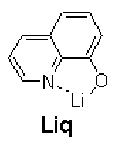

Finally, a cathode used as a second electrode is formed on the electron injection layer by vacuum thermal deposition of a cathode metal to complete an organic EL device.

The cathode metal may be lithium (Li), magnesium (Mg), aluminum (Al), aluminum-lithium (Al-Li), calcium (Ca), magnesium-indium (Mg-In), magnesium-silver (Mg-Ag), or the like.

The organic EL device of the present invention may include, as needed, one or two interlayers among the anode, the hole injection layer, the hole transport layer, the light emission layer, the electron transport layer, the electron injection layer, and the cathode. In addition to the above-mentioned layers, a hole-blocking layer or an electron-blocking layer may also be formed.

Hereinafter, the present invention will be described more specifically by Examples. However, the following Examples are provided only for illustrations and thus the present invention is not limited to or by them.

### EXAMPLE 1

A corning 15Ω/cm² (1,200Å) ITO glass substrate was cut into pieces of 50 mm x 50 mm x 0.7 mm in size, followed by ultrasonic cleaning in isopropyl alcohol and deionized water (5 minutes for each) and then UV/ozone cleaning (30 minutes), to be used as an anode.

A hole transport layer was formed to a thickness of 600Å on the substrate by vacuum deposition of N,N'-di(1-naphthyl)-N,N'-diphenylbenzidine (NPD).

A light emission layer was formed to a thickness of about 400Å on the hole transport layer by co-deposition of a mixture of 50 parts by weight of (4-biphenylyl)-5-(4-t-butylphenyl)-1,3,4-oxdadiazole with an electron transport property and 50 parts by weight of 4,4'-biscarbazolylbiphenyl with a hole transport property as a host and 10 parts by weight of bis(benzothienylpyridine)acetylacetonate iridium as a phosphorescent dopant.

An electron transport layer was formed to a thickness of about 300Å on the light emission layer by deposition of Alq3 used as an electron transport material.

A Lif/Al electrode was formed on the electron transport layer by sequential vacuum deposition of LiF (10Å, electron injection layer) and Al (1,000Å, cathode) to complete an organic EL device.

### COMPARATIVE EXAMPLE 1

A corning 15Ω/cm² (1,200Å) ITO glass substrate was cut into pieces of 50 mm x 50 mm x 0.7 mm in size, followed by ultrasonic cleaning in isopropyl alcohol and deionized water (5 minutes for each) and then UV/ozone cleaning (30 minutes), to be used as an anode.

A hole transport layer was formed to a thickness of 600Å on the substrate by vacuum deposition of NPD. A light emission layer was then formed to a thickness of 400Å on the hole transport layer by co-deposition of 4,4'-biscarbazolylbiphenyl as a host and 10 parts by weight of bis(benzothienylpyridine)acetylacetonate iridium as a phosphorescent dopant.

An electron transport layer was formed to a thickness of about 300Å on the light emission layer by deposition of Alq3 used as an electron transport material.

A Lif/Al electrode was formed on the electron transport layer by sequential vacuum deposition of LiF (10Å, electron injection layer) and Al (1,000Å, cathode) to complete an organic EL device.

Emission efficiency and lifetime characteristics for the organic EL devices manufactured in Example 1 and Comparative Example 1 were evaluated.

As a result, the organic EL device of Example 1 exhibited enhanced emission efficiency of 5.5 cd/A, as compared to the emission efficiency (about 4.3 cd/A) of the organic EL device of Comparative Example 1.

Furthermore, the organic EL device of Example 1 also exhibited enhanced lifetime characteristics relative to the organic EL device of Comparative Example 1.

According to an organic EL device of the present invention, a light emission layer producing phosphorescent emission is formed using a host including a carbazole compound with a hole transport property and one or more selected from an oxadiazole compound, a phenanthroline compound, a triazine compound, and a triazole compound with an electron transport property. The organic EL device of the present invention has improved device efficiency and lifetime characteristics even in the absence of a hole-blocking layer.

## Claims

1. An organic electroluminescent device, comprising:
a pair of electrodes; and
a light emission layer between the pair of electrodes, the light emission layer comprising a phosphorescent dopant and a host, the host comprising (i) a hole transporting compound and (ii) at least one selected from the group consisting of an oxadiazole compound, a phenanthroline compound, a triazine compound, and a triazole compound.

2. The organic EL device of claim 1, wherein the oxadiazole compound is (4-biphenylyl)-5-(4-t-butylphenyl)-1,3,4-oxadiazole.

3. The organic EL device of claim 1, wherein the phenanthroline compound is 2,9-dimethyl-4,7-diphenyl-9,10-phenanthroline.

4. The organic EL device of claim 1, wherein the triazine compound is 2,4,6-tris(diarylamino)-1,3,5-triazine, 2,4,6-tris(diphenylamino)-1,3,5-triazine, 2,4,6-tricarbazolo-1,3,5-triazine, 2,4,6-tris(N-phenyl-2-naphthylamino)-1,3,5-triazine, 2,4,6-tris(N-pheyl-1-naphthylamino)-1,3,5-triazine, or 2,4,6-trisbiphenyl-1,3,5-triazine.

5. The organic EL device of claim 1, wherein the triazole compound is 3-phenyl-4-(1'-naphthyl)-5-phenyl-1,2,4-triazole.

6. The organic EL device of claim 1, wherein the hole transporting compound is a carbazole compound.

7. The organic electroluminescent device of claim 6, wherein the carbazole compound is at least one selected from the group consisting of 1,3,5-tricarbazolylbenzene, 4,4'-biscarbazolylbiphenyl, polyvinylcarbazole, m-biscarbazolylphenyl, 4,4'-biscarbazolyl-2,2'-dimethylbiphenyl, 4',4"-tri(N-carbazolyl)triphenylamine, 1,3,5-tri(2-carbazolylphenyl)benzene, 1,3,5-tris(2-carbazolyl-5-methoxyphenyl)benzene, and bis(4-carbazolylphenyl)silane.

8. The organic electroluminescent device of claim 1, wherein the content of the host in the light emission layer is 80 to 99 parts by weight, based on the total weight 100 parts by weight of the light emission layer.

9. The organic electroluminescent device of claim 1, wherein the content of the at least one selected from the group consisting of the oxadiazole compound, the phenanthroline compound, the triazine compound, and the triazole compound in the light emission layer is 5 to 2,000 parts by weight, based on 100 parts by weight of the hole transporting compound compound.

10. The organic electroluminescent device of claim 1, wherein the phosphorescent dopant is at least one selected from the group consisting of bisthienylpyridine acetylacetonate iridium, bis(benzothienylpyridine)acetylacetonate iridium, bis(2-phenylbenzothiazole)acetylacetonate iridium, bis(1-phenylisoquinoline) iridium acetylacetonate, tris(1-phenylisoquinoline) iridium, tris(phenylpyridine) iridium, tris(2-biphenylpyridine) iridium, tris(3-biphenylpyridine) iridium, and tris(4-biphenylpyridine) iridium.

11. The organic electroluminescent device of claim 1, wherein an electron transport layer is formed directly on the light emission layer.

12. An organic electroluminescent device, comprising:
a substrate;
a first electrode formed on the substrate;
a hole injection layer formed on the the first electrode;
a light emission layer comprising a phosphorescent dopant and a host, the host comprising (i) a first compound comprising a carbazole compound and (ii) a second compound comprising at least one selected from the group consisting of an oxadiazole compound, a phenanthroline compound, a triazine compound, and a triazole compound;
an electron transport layer formed on the light emission layer; and
a second electrode formed on the electron transport layer.

13. The organic electroluminescent device of claim 12, wherein the electron transport layer is formed directly on the light emission layer.

14. The organic electroluminescent device of claim 12, further comprising:
a hole transport layer between the hole injection layer and the light emission layer.

15. The organic electroluminescent device of claim 12, further comprising:
an electron injection layer between the electron transport layer and the second electrode.

16. The organic electroluminescent device of claim 12, wherein the oxadiazole compound is (4-biphenylyl)-5-(4-t-butylphenyl)-1,3,4-oxadiazole, the phenanthroline compound is 2,9-dimethyl-4,7-diphenyl-9,10-phenanthroline, the triazine compound is 2,4,6-tris(diarylamino)-1,3,5-triazine, 2,4,6-tris(diphenylamino)-1,3,5-triazine, 2,4,6-tricarbazolo-1,3,5-triazine, 2,4,6-tris(N-phenyl-2-naphthylamino)-1,3,5-triazine, 2,4,6-tris(N-pheyl-1-naphthylamino)-1,3,5-triazine, or 2,4,6-trisbiphenyl-1,3,5-triazine, and the triazole compound is 3-phenyl-4-(1'-naphthyl)-5-phenyl-1,2,4-triazole.

17. The organic electroluminescent device of claim 12, wherein the carbazole compound is at least one selected from the group consisting of 1,3,5-tricarbazolylbenzene, 4,4'-biscarbazolylbiphenyl, polyvinylcarbazole, m-biscarbazolylphenyl, 4,4'-biscarbazolyl-2,2'-dimethylbiphenyl, 4',4"-tri(N-carbazolyl)triphenylamine, 1,3,5-tri(2-carbazolylphenyl)benzene, 1,3,5-tris(2-carbazolyl-5-methoxyphenyl)benzene, and bis(4-carbazolylphenyl)silane.

18. The organic electroluminescent device of claim 12, wherein the content of the host in the light emission layer is 80 to 99 parts by weight, based on the total weight 100 parts by weight of the light emission layer.

19. The organic electroluminescent device of claim 12, wherein the content of the second compound is 5 to 2,000 parts by weight, based on 100 parts by weight of the carbazole compound.

20. The organic electroluminescent device of claim 12, wherein the thickness of the light emission layer is in the range from 100 to 800Å.

21. An organic electroluminescent device, comprising:
a pair of electrodes; and
a organic layer between the pair of electrodes, the organic layer comprising a light emission layer and an absent hole blocking layer, the light emission layer comprising a phosphorescent dopant and a host, the host comprising (i) a first compound comprising a carbazole compound and (ii) a second compound comprising at least one selected from the group consisting of an oxadiazole compound, a phenanthroline compound, a triazine compound, and a triazole compound, the content of the host being 80 to 99 parts by weight based on the total weight 100 parts by weight of the light emission layer, the content of the second compound being 5 to 2,000 parts by weight based on 100 parts by weight of the carbazole compound.
